# EUROPÄISCHE PATENTSCHRIFT

(11) **EP 2 549 520 B1**
(45) Veröffentlichungstag und Bekanntmachung des Hinweises auf die Patenterteilung: **08.10.2014**
(21) Anmeldenummer: 12400028.2
(22) Anmeldetag: 20.07.2012
(51) Int. Cl.: H01J 37/31, H01J 37/315, H01J 37/06, H01J 37/18, H01J 37/16, B23K 15/10

(54) **Teilchenstrahlgenerator mit verbessertem Vakuum**
Particle beam generator with improved vacuum
Générateur de rayons de particules avec vide amélioré

(30) Priorität: 22.07.2011 DE 102011108187
(43) Veröffentlichungstag der Anmeldung: 23.01.2013
(73) Patentinhaber: Zosel, Karsten, 82256 Fürstenfeldbruck (DE)
(72) Erfinder: Zosel, Karsten, 82256 Fürstenfeldbruck (DE)

(56) Entgegenhaltungen:
- DE-A1- 3 428 207
- DE-C- 276 396
- JP-U- 55 092 491
- US-A- 2 411 290
- US-A- 3 585 348
- US-A1- 2006 163 498
- SCHULZE K-R: "Komm raus, Strahl!", SCHWEISSEN UND SCHNEIDEN, DVS VERLAG, DUSSELDORF, DE, Bd. 63, Nr. 9, 1. September 2011 (2011-09-01), Seiten 536-542, XP001569377, ISSN: 0036-7184

## Beschreibung

Die vorliegende Erfindung betrifft einen Teilchenstrahlgenerator wie einen Elektronenstrahlgenerator, der einen Teilchenstrahl zur Bearbeitung von Werkstücken erzeugt.

Beim Bohren oder Schweißen mittels eines Teilchenstrahls wie eines Elektronenstrahls kann ein zu bearbeitendes Werkstück in einer Vakuumkammer platziert werden. Die Vakuumkammer kann eine Bewegungseinrichtung für das Werkstück enthalten. Auf der Vakuumkammer kann ein Elektronenstrahlgenerator montiert sein, der den zur Bearbeitung verwendeten Elektronenstrahl erzeugt.

Bei bekannten Elektronenstrahlgeneratoren wird zur Freisetzung von Elektronen eine thermische Emission verwendet. Dabei wird bisher vorwiegend eine Wolframkathode benutzt, die zur Erzeugung von Elektronen erhitzt wird, wobei auf einer relativ großen Kathodenfläche Elektronen erzeugt werden, die anschließend zur Erzeugung des Elektronenstrahls beschleunigt werden. Es wäre jedoch vorteilhaft, Elektronen auf einer kleineren Kathodenfläche erzeugen zu können, da dann an einer Bearbeitungsstelle des Werkstücks ein Strahl mit einem geringeren Querschnitt erhalten werden könnte. Dies wäre insbesondere bei der Fugensuche bei kleinen Spalten von Vorteil. Dazu ist es jedoch notwendig, Materialien und Verfahren zur Erzeugung von Elektronen einzusetzen, für die ein wesentlich besseres Vakuum innerhalb des Elektronenstrahlgenerators erforderlich ist, als bei herkömmlichen Elektronenstrahlgeneratoren erreicht werden kann.

Bei bekannten Elektronenstrahlbearbeitungsvorrichtungen beträgt der Druckunterschied zwischen dem Strahlerzeugungsraum des Teilchenstrahlgenerators und der Vakuumkammer wenige Zehnerpotenzen. Will man größere Druckunterschiede erreichen, kann man mehrere, durch jeweilige Lochblenden voneinander getrennte Vakuumstufen verwenden, an die jeweils eine separate Pumpe angeschlossen werden kann. Dadurch wird jedoch der von dem Elektronenstrahl zurückgelegte Weg deutlich länger, und die Qualität des Elektronenstrahls verschlechtert sich.

Die Veröffentlichung "A Mechanical Beam Chopper System for the Measurement of Half-Lives in the Millisecond Region" von A. Hashizume et al. in der Zeitschrift Nuclear Instruments and Methods, 119, 1974, S. 209-212 betrifft einen mechanischen Strahlzerhacker für einen Protonenstrahl, der hinter einer Strahlaustrittsöffnung eines Zyklotrons angeordnet ist und eine durch einen Motor angetriebene Scheibe mit einer oder mehreren Öffnungen aufweist, mit der der Protonenstrahl zerhackt werden kann.

Die US 2006/0163498 A1 betrifft eine Ionenimplantiervorrichtung mit einem Ionenstrahlgenerator, der eine drehbare Scheibe mit Strahldurchgangsöffnungen aufweist, die zum Zerhacken des Ionenstrahls und Erzeugen eines gepulsten Strahls ausgebildet ist.

Die Dokumente DE 34 28 207 A1 und US 3 585 348 A gehören zum technischen Hintergrund der aktuellen Anmeldung und offenbaren, wie die Elektronenquelle einer Teilchenstrahlbearbeitungsanlage vor schlechtem Vakuum geschützt werden kann. DE 34 28 207 A1 offenbart rotierende Scheiben als Abgrenzung des Strahldurchtrittsbereiches und zur Reduktion der Verschmutzung der Elektronensäule. US 3 585 348 A offenbart eine zusätzliche differentielle Pumpstufe in Form einer Abpumpkammer die mit angeschlossenen Pumpen in Verbindung steht. Das Dokument JP 355092491 U offenbart ein Teilchenstrahlgerät welches ein Ventil mit rotierbarem Ventilkörper aufweist, welches zwischen einem ersten und einem zweiten Gehäuseabschnitt angeordnet ist und im Strahlengang des Teilchenstrahls liegt.

Der Erfindung liegt die Aufgabe zugrunde, einen Teilchenstrahlgenerator anzugeben, der eine Strahlerzeugung mit hoher Qualität in einem besseren Vakuum ermöglicht.

Diese Aufgabe wird gelöst durch einen Teilchenstrahlgenerator nach Anspruch 1. Weiterbildungen der Erfindung sind in den abhängigen Ansprüchen angegeben.

Erfindungsgemäß wird das bessere Vakuum in dem Strahlerzeugungsraum des Teilchenstrahlgenerators dadurch erreicht, dass eine Pumpe, die den Strahlerzeugungsraum evakuiert, in das Gehäuse des Teilchenstrahlgenerators integriert ist. Auf diese Weise kann die auf dem Weg des Elektronenstrahls zur Arbeitskammer angeordnete Pumpe die Teilchen, die aus der Arbeitskammer in Richtung des Strahlerzeugungsraums driften, in die Arbeitskammer zurückpumpen. Zugleich kann durch die rotierenden Schaufeln der Pumpe der Weg von Teilchen, die sich in Richtung des Strahlerzeugungsraums bewegen, blockiert werden. Der Elektronenstrahl verläuft dabei beispielsweise parallel zur Drehachse der Pumpenschaufeln und in Richtung des Außenumfangs derselben versetzt. Der Elektronenstrahl wird synchron zur Drehung der Pumpenschaufeln gepulst, so dass er die Pumpenschaufeln passieren kann. Das Vorliegen eines besseren Vakuums ermöglicht beispielsweise die Nutzung des Fotoeffekts zur Freisetzung von Elektronen. Dabei wird beispielsweise ein Laser als Lichtquelle benutzt, was zudem ein sehr schnelles Ein- und Ausschalten des Elektronenstrahls ermöglicht, das insbesondere günstig für Elektronenstrahlbohren ist.

Weitere Merkmale und Zweckmäßigkeiten ergeben sich aus der Beschreibung von beispielhaften Ausführungsformen anhand der Figuren. Es zeigen:
Fig. 1 einen Schnitt durch eine Ausführungsform eines Teilchenstrahlgenerators mit integrierter Pumpe,
Fig. 2 einen vergrößerten schematischen Schnitt durch eine Pumpe einer Ausführungsform,
Fig. 3 eine vereinfachte schematische Draufsicht auf einen Stator einer Pumpe einer Ausführungsform,
Fig. 4 eine vereinfachte schematische Draufsicht auf einen Rotor einer Pumpe einer Ausführungsform,
Fig. 5 eine vereinfachte schematische Draufsicht auf einen Rotor einer Pumpe einer Ausführungsform,
Fig. 6 eine vereinfachte schematische Draufsicht auf einen Rotor einer Pumpe einer Ausführungsform,
Fig. 7 eine vereinfachte schematische Draufsicht auf einen Stator einer Pumpe einer Ausführungsform,
Fig. 8 eine vereinfachte schematische Draufsicht auf einen Stator einer Pumpe einer Ausführungsform, und
Fig. 9 einen vergrößerten schematischen Schnitt durch eine Pumpe einer Ausführungsform mit einer Steuerung der Strahlerzeugung.

Nachfolgend werden Ausführungsformen unter Bezugnahme auf die Figuren beschrieben. Gleiche Merkmale sind in allen Figuren mit gleichen Bezugszeichen bezeichnet.

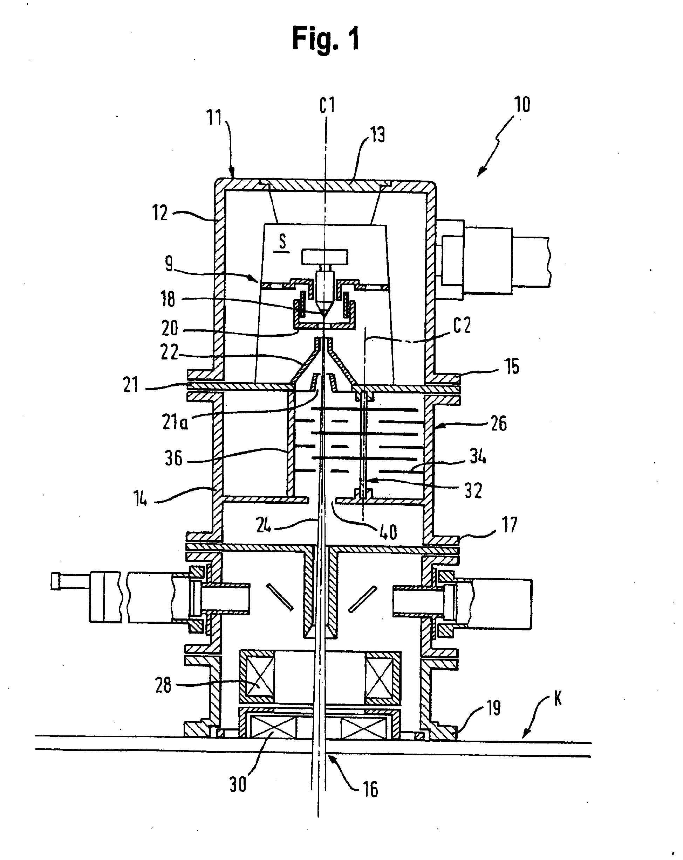

Die Fig. 1 zeigt einen Querschnitt durch eine Ausführungsform eines Teilchenstrahlgenerators mit verbessertem Vakuum. Der Teilchenstrahlgenerator 10 weist ein Gehäuse 11 auf. Das Gehäuse 11 ist bei diesem Beispiel ein einseitig offener Hohlzylinder, dessen offenes Ende eine Austrittsöffnung 16 aufweist. Das gegenüberliegende Ende des Gehäuses 11 ist beispielsweise durch einen abnehmbaren Deckel 13 verschlossen. Wie in Fig. 1 gezeigt ist, kann das Gehäuse 11 aus mehreren Abschnitten bestehen, die über Flansche 15, 17 vakuumdicht miteinander verbunden sind. An dem offenen Ende des Gehäuses 11 ist an der Außenseite ein umlaufender Flansch 19 vorgesehen, über den das Gehäuse 11 und damit der Teilchenstrahlgenerator 10 an einer Kammerwand einer Vakuumkammer K befestigt werden kann.

An dem geschlossenen Ende des Gehäuses 11 befindet sich ein erster Gehäuseabschnitt 12, der einen Strahlerzeugungsraum S festlegt. An dem ersten Gehäuseabschnitt ist ein Anschluss (nicht gezeigt) für eine externe Vakuumpumpe vorgesehen, die auf bekannte Weise zur Evakuierung des Strahlerzeugungsraums S verwendet werden kann. In dem Strahlerzeugungsraum S des ersten Abschnitts 12 ist eine Strahlerzeugungsvorrichtung 9 zur Erzeugung eines Teilchenstrahls, bei diesem Beispiel eines Elektronenstrahls, vorgesehen. Die Strahlerzeugungsvorrichtung 9 weist eine Kathode 18, eine Anode 22 und einen zwischen der Kathode 18 und der Anode 22 angeordneten Wehnelt-Zylinder 20 auf. Die Strahlerzeugungsvorrichtung kann einen Teilchenstrahl 24 entlang einer Strahlachse C1 erzeugen, indem aus der Kathode ausgelöste Elektronen durch das elektrische Feld zwischen Kathode und Anode beschleunigt werden. Die Strahlerzeugungsvorrichtung 9 ist derart angeordnet, dass die entlang der Strahlachse C 1 beschleunigten Elektronen in Richtung der Austrittsöffnung 16 des Gehäuses 11 beschleunigt werden, das heißt, die Strahlachse C1 geht durch die Austrittsöffnung 16.

Im Anschluss an den ersten Gehäuseabschnitt 12 weist das Gehäuse 11 einen zweiten Gehäuseabschnitt 14 auf. Der zweite Gehäuseabschnitt 14 kann, wie in Fig. 1 gezeigt, an den ersten Gehäuseabschnitt 12 angeflanscht sein, er kann jedoch ebenfalls einstückig mit demselben ausgebildet sein. Der zweite Gehäuseabschnitt 14 ist über eine geeignete Öffnung derart mit dem ersten Gehäuseabschnitt 12 verbunden, dass der Teilchenstrahl 24 entlang der Strahlachse C 1 in Richtung der Austrittsöffnung 16 durch den zweiten Gehäuseabschnitt durchgehen kann. Dabei kann, wie in Fig. 1 gezeigt, zwischen dem ersten Gehäuseabschnitt 12 und dem zweiten Gehäuseabschnitt 14 eine Trennwand 21 mit einer darin ausgebildeten Strahldurchgangsöffnung 21 a vorgesehen sein, die verschließbar ausgebildet sein kann, so dass der evakuierte Strahlerzeugungsraum S von dem Rest des Teilchenstrahlgenerators abgetrennt werden kann, beispielsweise bei einem Wechsel des Werkstücks in der Arbeitskammer K.

In dem zweiten Gehäuseabschnitt 14 ist eine Pumpe 26 angeordnet, die derart ausgebildet ist, dass sie die Erzeugung eines verbesserten Vakuums in dem Strahlerzeugungsraum S ermöglicht, indem sie Teilchen aus dem Strahlerzeugungsraum S in Richtung der Austrittsöffnung 16 abpumpt und in Richtung des Strahlerzeugungsraums S zurückdriftende Teilchen aufhält. Die Pumpe 26 wirkt dabei im Wesentlichen wie eine Vielzahl von Druckstufen. Die Pumpe 26 ist bei der vorliegenden Ausführungsform als eine Turbomolekularpumpe ausgebildet, die im Folgenden genauer beschrieben wird.

Die Pumpe 26 weist ein Pumpengehäuse 36 auf, in dem ein Rotor 32 drehbar gelagert ist, der über einen (nicht gezeigten) Motor der Pumpe 26 zur Drehung um eine Drehachse C2 angetrieben werden kann. Bei der vorliegenden Ausführungsform verläuft die Drehachse C2 in einem Abstand parallel zu der Strahlachse C1. Dabei kann das Pumpengehäuse 36 auch zumindest teilweise von dem Gehäuse 11 des Teilchenstrahlgenerators 10 gebildet werden. Die Strahlachse C1 des Teilchenstrahls 24 verläuft durch das Pumpengehäuse 36. An dem Pumpengehäuse 36 sind Statorschaufeln eines Stators 34 angebracht, die bezüglich des Pumpengehäuses 36 ortsfest sind. Wie im Folgenden genauer beschrieben wird, sind der Rotor 32 und die Statorschaufeln der Pumpe 26 derart ausgebildet, dass an mindestens einer Rotorposition ein ungehinderter Durchgang des Teilchenstrahls entlang der Strahlachse C1 durch den zweiten Gehäuseabschnitt 14 mit der Pumpe 26 gewährleistet ist. Auf diese Weise können sowohl der Teilchenstrahl, der geeignet gepulst sein kann, als auch die aus dem Strahlerzeugungsraum S abgepumpten Teilchen über eine Auslassöffnung 40 aus dem zweiten Abschnitt 14 des Gehäuses 11 des Teilchenstrahlgenerators 10 austreten.

Im Anschluss an den zweiten Gehäuseabschnitt 14 können einer oder mehrere weitere Gehäuseabschnitte vorgesehen sein, die beispielsweise eine Elektronenoptik, ein Strahldiagnosesystem sowie ein elektromagnetisches System mit unter anderem einer Fokussierspule 28 und einer Ablenkspule 30 aufweisen können.

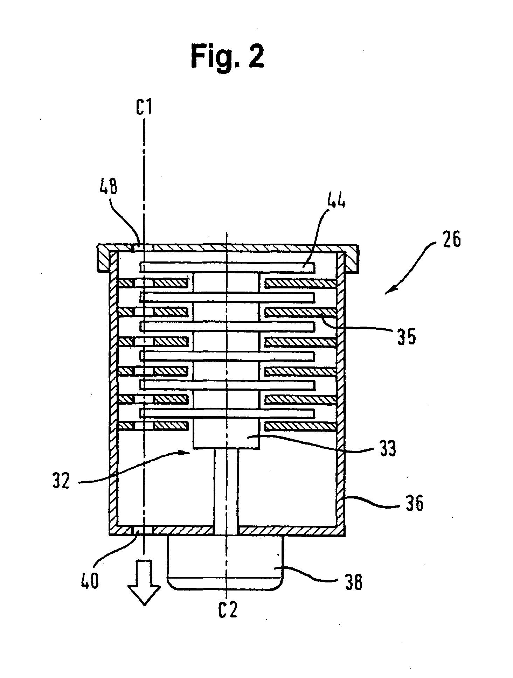

Bei der in dem Gehäuse 11 des Teilchenstrahlgenerators 10 verbauten Pumpe 26 handelt es sich beispielsweise um eine Turbomolekularpumpe. Der Aufbau solch einer Turbomolekularpumpe wird im Folgenden unter Bezugnahme auf die Fig. 2 genauer beschrieben.

Die Fig. 2 zeigt eine schematische Schnittansicht einer zur Verwendung mit dem Teilchenstrahlgenerator 10 einer Ausführungsform angepassten Turbomolekularpumpe 26. Die Turbomolekularpumpe 26 weist das Gehäuse 36 auf, das hier die Form eines Hohlzylinders aufweist. An einem Ende des Gehäuses 36 befindet sich eine Ansaugöffnung 48, durch die bei einem Pumpenbetrieb Teilchen aus dem Raum vor der Ansaugöffnung 48 in das Innere des Pumpengehäuses 36 gesaugt werden. In dem Pumpengehäuse 36 ist der Rotor 32 angeordnet, der über eine Welle durch einen an dem Pumpengehäuse montierten Motor 38, wie einem Elektromotor, zur Drehung um die Drehachse C2 angetrieben wird. Eine typische Drehzahl des Rotors solch einer Turbomolekularpumpe liegt beispielsweise im Bereich von mehreren zehntausend Umdrehungen pro Minute. Der Rotor weist einen mit der Antriebswelle verbundenen Rotorkörper 33 auf, an dem mehrere Ebenen von sich jeweils radial erstreckenden Rotorschaufeln 44 entlang des Umfangs des Rotorkörpers angeordnet sind. Zwischen den Ebenen der Rotorschaufeln 44 sind gehäuseseitig Statorschaufeln 35 des Stators 34 angeordnet.

Im Allgemeinen enthält eine Turbomolekularpumpe eine Mehrzahl von jeweils in einer Ebene angeordneten Rotorschaufelanordnungen sowie eine entsprechende Mehrzahl von zwischen den Ebenen der Rotorschaufeln vorgesehenen Statorschaufelanordnungen. Dabei sind die Rotorschaufeln bezüglich der axialen Richtung der Pumpe geneigt. Die an dem Pumpengehäuse angebrachten Statorschaufeln sind entsprechend in die entgegengesetzte Richtung geneigt, so dass bei einer Drehung der Rotorschaufeln Teilchen, die durch die Ansaugöffnung angesaugt werden, in Richtung des Pumpeninneren gefördert werden. Die Pumpe 26 ist dabei derart ausgebildet, dass bei einem Pumpenbetrieb ein durch die Ansaugöffnung 48 eintretender Teilchenstrahl durch die Auslassöffnung 40 auf der anderen Seite des Pumpengehäuses 36 austreten kann. Dies kann auf unterschiedliche Weisen erreicht werden.

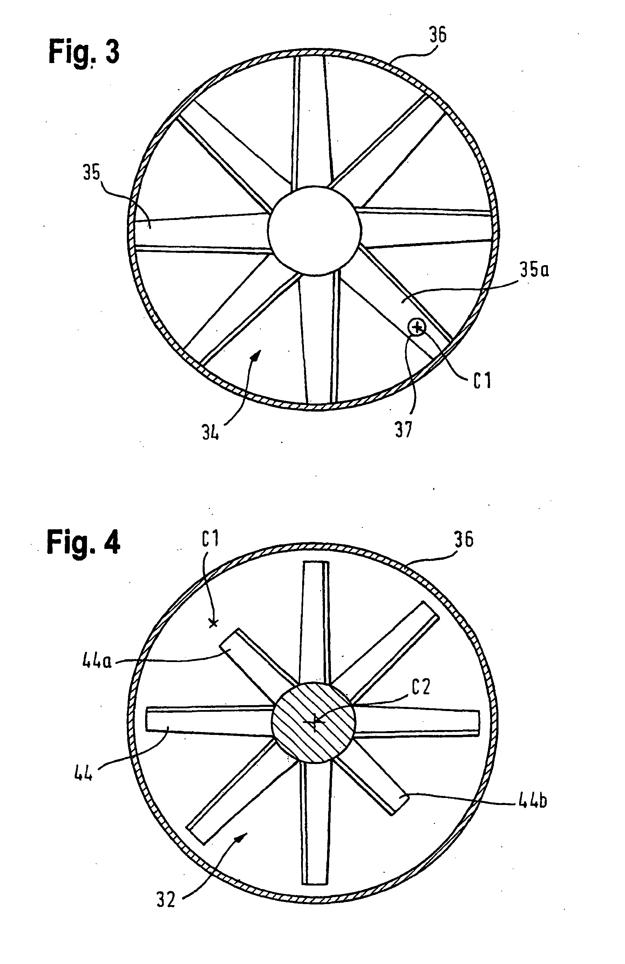

Eine Möglichkeit ist schematisch in den Fig. 2, 3 und 4 gezeigt. Die Fig. 3 zeigt eine schematische Draufsicht auf die Statorschaufeln 35 aus Fig. 2, und die Fig. 4 zeigt eine schematische Draufsicht auf die Rotorschaufeln 44 aus Fig. 2.

Die Statorschaufeln 35 sind in Draufsicht in regelmäßigen Abständen angeordnet, wobei sie auch so dicht stehen können, dass sie den gesamten Querschnitt der Pumpe 26 überdecken. In mindestens einer Statorschaufel 35a, durch die die Strahlachse C1 geht, ist eine Öffnung 37 ausgebildet, durch die der Teilchenstrahl durchgehen kann. Entsprechende Öffnungen sind auch in allen anderen Ebenen ausgebildet. Ferner ist zum Ermöglichen eines Durchgangs des Teilchenstrahls durch die Pumpe die Anordnung der Rotorschaufeln 44 in den jeweiligen Ebenen angepasst. Dies kann beispielsweise dadurch geschehen, dass einige ausgewählte Rotorschaufeln 44a, 44b der Rotorschaufeln 44, beispielsweise zwei gegenüberliegende Rotorschaufeln 44a, 44b, verkürzt sind, wie in Fig. 4 gezeigt ist. Auf diese Weise durchläuft der Rotor 32 bei einer Drehung eine oder mehrere Drehstellungen, an denen in dem Bereich des Strahldurchgangs keine Rotorschaufeln angetroffen werden. Mit anderen Worten ergibt sich bei einer Drehung des Rotors mit einer bestimmten Drehzahl in regelmäßigen Abständen ein ungehinderter Durchgang des Teilchenstrahls durch die Pumpe 26.

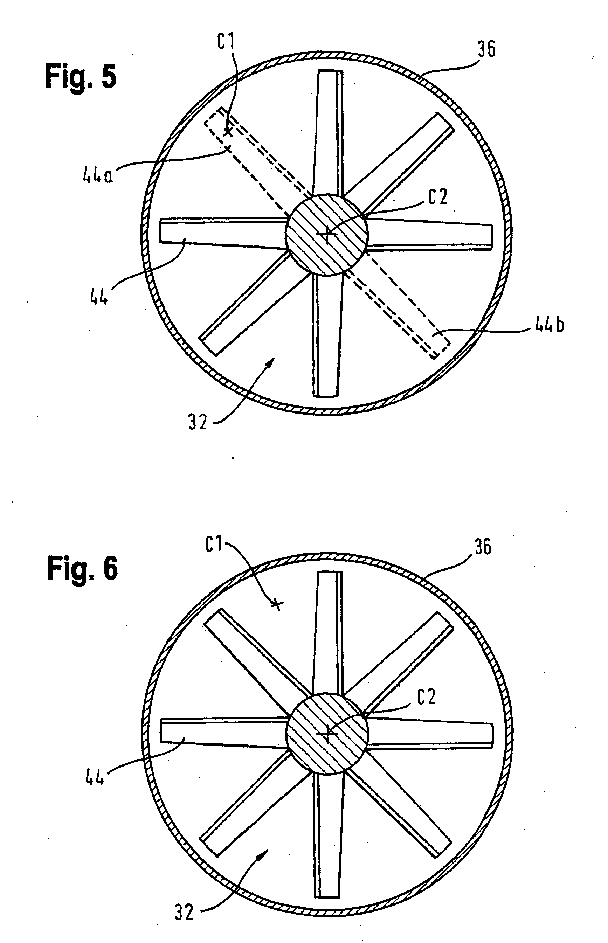

Alternativ dazu könnten, wie in Fig. 5 gezeigt, die Rotorschaufeln 44a, 44b auch weggelassen werden oder, wie in Fig. 6 gezeigt, die Rotorschaufeln 44 auch weniger dicht angeordnet sein, so dass zwischen jeweils zwei benachbarten Rotorschaufeln der Teilchenstrahl passieren kann. Bei dem in Fig. 6 gezeigten Rotor 32 sind daher die Rotorschaufeln 44 in solchen Abständen angeordnet, dass sie in der Draufsicht die Querschnittsfläche der Pumpe 26 nicht vollständig bedecken.

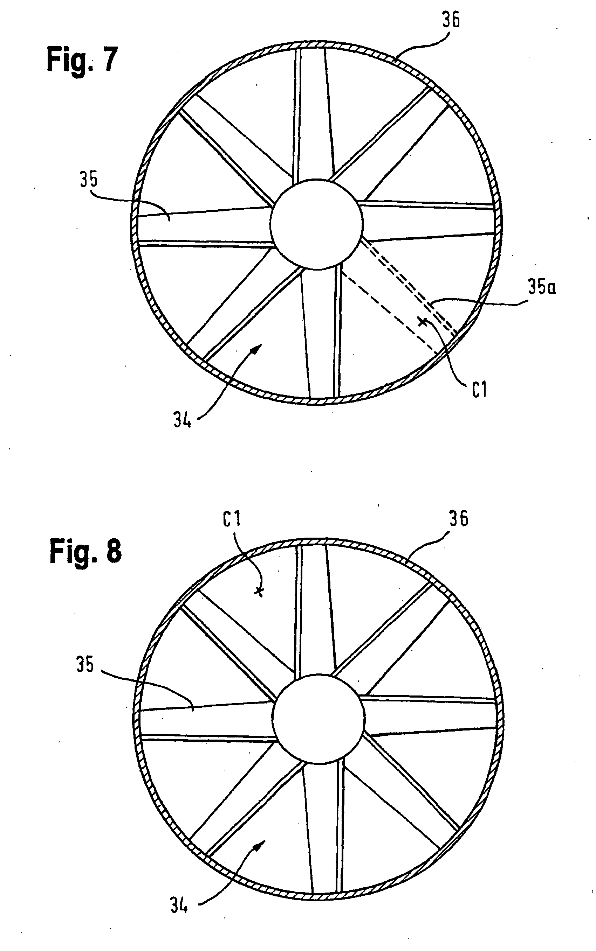

Alternative Anordnungen der Statorschaufeln 3 5 sind in den Fig. 7 und 8 gezeigt. Wie in Fig. 7 gezeigt, kann eine Statorschaufel 35a der Statorschaufeln 35 an der Position der Strahlachse C1 weggelassen bzw. entfernt sein. Ferner könnten die Statorschaufeln 35 auch, wie in Fig. 8 gezeigt, mit solchen Abständen zwischen denselben angeordnet sein, dass der Teilchenstrahl zwischen diesen hindurchtreten kann.

Wie vorher beschrieben, wird durch den Einbau einer auf geeignete Weise ausgebildeten Turbomolekularpumpe in das Gehäuse 11 des Teilchenstrahlgenerators 10 an einer geeigneten Position ermöglicht, dass während eines Betriebs der Pumpe 26 in regelmäßig wiederkehrenden Zeitintervallen ein Durchgang des Teilchenstrahls 24 durch die Pumpe 26 entlang der Strahlachse C1 und damit ein Austritt desselben durch die Austrittsöffnung 16 ermöglicht wird. Auf diese Weise kann der Strahlerzeugungsraum S ständig durch die unmittelbar angrenzend an denselben vorgesehene Turbomolekularpumpe abgepumpt werden, während ein Zurückströmen von Teilchen in den Strahlerzeugungsraum durch die Rotorschaufeln 44 der Pumpe 26 verhindert wird. Daher kann in dem Strahlerzeugungsraum S ein deutlich besseres Vakuum erhalten werden, als bei herkömmlichen Teilchenstrahlgeneratoren, bei denen lediglich eine Pumpe außerhalb des Teilchenstrahlgeneratorgehäuses vorgesehen ist. Dies wird zumindest teilweise dadurch erreicht, dass Teilchen, die von der Pumpe 26 in Richtung der Austrittsöffnung 16 abgepumpt worden sind, nicht mehr ohne Weiteres zurück in den Arbeitsraum S gelangen können, da sie auf dem Weg dorthin ständig auf die sehr schnell rotierenden Rotorschaufeln der Pumpe treffen, was ihre Bewegung in Richtung des Strahlerzeugungsraums S behindert.

Aus dem vorher Beschriebenen ist offensichtlich, dass die Erzeugung des Teilchenstrahls vorteilhafter Weise synchronisiert mit dem Pumpenbetrieb erfolgen sollte, das heißt, dass der Teilchenstrahl gepulst erzeugt wird, und zwar derart, dass er immer gerade dann erzeugt wird, wenn die Stellung des Rotors 32 einen Durchgang des Teilchenstrahls durch die Pumpe 26 erlaubt. Dies wird im Folgenden genauer beschrieben.

Wie aus Fig. 2 ersichtlich ist, ist die Pumpe 26 beispielsweise derart in den Teilchenstrahlgenerator 10 eingebaut, dass der Teilchenstrahl in Richtung des Außenumfangs der Pumpe 26 versetzt und parallel zu der Drehachse C2 des Rotors 32 verläuft. Die Drehachse C2 kann jedoch auch unter einem Winkel zu der Strahlachse C1 verlaufen. Bei einer Ausführungsform dreht sich der Rotor 32 der Turbomolekularpumpe 26 mit etwa 30000 U/min. Bei einem beispielsweise wie in den Fig. 4 und 5 ausgebildeten Rotor, bei dem in jeder Rotorebene zwei Bereiche von Rotorstellungen vorhanden sind, in denen der Teilchenstrahl entlang der Achse C1 durch die Rotorschaufeln 44 hindurchgehen kann, ohne diese zu treffen, ermöglicht dies das Aussenden von 60000 Teilchenstrahlpulsen pro Minute bzw. 1000 Pulsen pro Sekunde. Dies entspricht einem gepulsten Betrieb eines Teilchenstrahls wie er beispielsweise auf vorteilhafte Weise beim Teilchenstrahlbohren verwendet werden kann. Ferner lässt sich auf diese Weise eine Frequenz der Teilchenstrahlpulse erzielen, die hoch genug ist, um scheinbar kontinuierlich Schweißen zu können, während die Frequenz klein genug ist, um während eines Teilchenstrahlpulses eine Scanzeile für eine Fugensuche durchlaufen zu können.

Dadurch, dass der Teilchenstrahl auf seinem Weg zur Arbeitskammer K durch die Turbomolekularpumpe 26 hindurchgeführt wird, werden die im Strahlerzeugungsraum S vorhandenen Restgase kontinuierlich in Richtung der Arbeitskammer K aus dem Strahlerzeugungsraum S abgepumpt. Bei einer Ausführungsform kann die an dem ersten Gehäuseabschnitt 12 angeschlossene externe Vakuumpumpe den Großteil des Restgases aus dem Strahlerzeugungsraum abpumpen, beispielsweise etwa das Tausendfache der Pumpe 26. Bei einer anderen Ausführungsform kann die externe Vakuumpumpe weggelassen sein und lediglich die Pumpe 26 zum Abpumpen des Strahlerzeugungsraums verwendet werden, beispielsweise, indem die in Fig. 2 gezeigte Ansaugöffnung 48 entsprechend vergrößert wird. Die Pumpe 26 kann als eine Mehrzahl von n hintereinandergeschalteten Druckstufen aufgefasst werden, wobei n der Anzahl der Rotorebenen der Pumpe 26 entspricht. Die beispielsweise in Fig. 2 gezeigte Anordnung der Pumpe 26 in dem Weg des Teilchenstrahls hat weiter den Vorteil, dass aus dem Strahlerzeugungsraum S abgepumpte Teilchen nicht ohne Weiteres aus dem Bereich stromabwärts der Pumpe 26 durch diese zurück in den Strahlerzeugungsraum S gelangen können, da sie auf die Vielzahl von sehr schnell drehenden Rotorschaufeln 44 treffen. Aufgrund der sehr schnellen Geschwindigkeit der drehenden Rotorschaufeln 44 und der im Allgemeinen sehr dichten Anordnung derselben ist es äußerst unwahrscheinlich, dass ein in Richtung des Strahlerzeugungsraums S strömendes Teilchen nicht früher oder später auf eine Rotorschaufel 44 trifft und so eine radiale bzw. in Umfangsrichtung liegende Geschwindigkeitskomponente erhält. Dadurch kann in Verbindung mit der an dem ersten Gehäuseabschnitt angeschlossenen externen Vakuumpumpe das in dem Strahlerzeugungsraum S erreichbare Vakuum um mehrere Größenordnungen unter dem mit herkömmlichen Anordnungen erreichten liegen, bei denen lediglich eine solche an dem Gehäuse angeschlossene Vakuumpumpe verwendet wird. Beispielsweise kann der Druck im Inneren des Strahlerzeugungsraums S statt einigen 10⁻⁶ mbar theoretisch bis auf weniger als 10⁻¹⁰ mbar abgesenkt werden. Für ein besonders gutes Vakuum kann auch vorgesehen sein, den Strahlerzeugungsraum mit allen Einbauten auszuheizen, beispielsweise auf etwa 250° C.

Ein derart verbessertes Vakuum in dem Strahlerzeugungsraum S ermöglicht den Einsatz neuer Technologien zur Erzeugung eines Elektronenstrahls, insbesondere die Verwendung eines Lasers zur Freisetzung von Elektronen unter Ausnutzung des Fotoeffekts. Dabei können mittlerweile verfügbare preiswerte Laser eingesetzt werden, und auf diese Weise ist ein sehr schnelles Ein- und Ausschalten des Elektronenstrahls möglich, was ebenfalls besonders günstig für das Elektronenstrahlbohren ist. Dabei kann bei einer Ausführungsform statt der herkömmlichen Wolframkathode eine Fotokathode mit einem sehr großen Quantenwirkungsgrad eingesetzt werden, bei der theoretisch bei einem Quantenwirkungsgrad von 100% für einen Strom von 200 mA lediglich 1/2 Watt an Lichtleistung benötigt würde. Blaue Laserdioden mit einer Leistung von 1 Watt sind sehr kostengünstig erhältlich. Bei einem Einsatz einer derartigen Fotokathode entfällt der Aufwand für eine Elektrodenheizung. Auch eine schnelle Ansteuerung des Wehnelt-Zylinders kann unter Umständen unnötig sein, da die Strahlstärke fast beliebig schnell mit dem Laser gesteuert werden kann. Vorteilhafter Weise ist bei einer Ausführungsform ein Mittel zur schnellen Messung des aktuellen Strahlstromes vorgesehen, um den Laser nachzuregeln, da Adsorbatschichten auf der Fotokathode den Quantenwirkungsgrad derselben verändern können.

Bei einer Ausführungsform lässt sich solch eine Fotokathode mit einer Glasscheibe realisieren, die von oben, ggf. durch ein Eintrittsfenster von außerhalb des Teilchenstrahlgenerators, mit dem Laser belichtet wird und die auf der Emissionsseite beispielsweise eine sehr dünne alkalimetallhaltige Schicht aufweist. Die alkalimetallhaltige Schicht kann beispielsweise Cäsium oder Silber enthalten. Besonders vorteilhaft ist es, wenn die Glasscheibe drehbar ist, da dann an einer Stelle, an der keine Teilchen erzeugt werden, die aktive Schicht ständig regeneriert werden kann, indem sie beispielsweise durch Ionenbeschuss gesäubert und nachbeschichtet wird. Für eine niederohmige Stromzufuhr ist die Glasscheibe vorteilhafter Weise mit Ausnahme eines etwa 1 mm breiten Kreisrings mit Metall beschichtet. Alternativ können zur Erzeugung von Elektronen auch mehrere Laserdioden vorgesehen sein, die von schräg unten Licht auf die Fotokathode einstrahlen.

Bei einer anderen Ausführungsform kann die Fotokathode von unten durch eine oder mehrere in dem ersten Gehäuseabschnitt 12 angeordnete Laserdioden belichtet werden.

Es ist auch möglich, bei einer Ausführungsform die Form des Elektronenstrahls zu variieren, indem zusätzliche optische Mittel vorgesehen sind. Wird etwa auf der Fotokathode außer dem Hauptemissionsort für die Schweißelektronen ein weiterer Bereich belichtet, dann kann so durch eine geeignete elektronenoptische Abbildung auf einem zu bearbeitenden Werkstück eine Vorwärmzone ausgebildet werden.

Bei einer beispielhaften Ausführungsform des Teilchenstrahlgenerators ist es von Vorteil, wenn alle Bauteile, die sich etwa auf dem Kathodenpotenzial befinden, in ein Gehäuse eingebaut sind, das sich ebenfalls auf diesem Kathodenpotenzial befindet und das über einen Messwiderstand zur Ermittlung des Emissionsstromes direkt an die Hochspannungsversorgung angeschlossen ist. Dieses Gehäuse kann beispielsweise ein in dem in Fig. 1 gezeigten ersten Gehäuseabschnitt 12 vorgesehener Käfig sein, in dem auch bei einer hohen Spannung keine elektrischen Felder erzeugt werden.

Eine gegebenenfalls für die Wehnelt-Steuerung sowie für die Messung des Kathodenstromes und für die eventuell nötige Kathodenregenerierung benötigte Energiezufuhr nach innen ist beispielsweise über am oberen Ende des Gehäuses vorgesehene Solarzellen möglich. Alle Datenübertragungen erfolgen vorzugsweise mit Lichtleitern oder direkt über ein Paar aus einer Leuchtdiode und einer Fotodiode. Dadurch, dass die Emissionsquelle eine runde Fläche statt dem bisher verwendeten linearen Heizband sein kann, kann unter Umständen der üblicherweise verwendete Stigmator entfallen, zumal auch das sonst störende Magnetfeld des Heizstromes wegfällt. Da der Laserstrahl bezüglich der Öffnung des Wehnelt-Zylinders ausgerichtet werden kann, entfällt auch eine sonst für eine Nachkorrektur benötigte Zentrierspule. Es kann auch eine Mechanik für den Wehnelt-Zylinder vorgesehen sein, so dass verschieden große Öffnungen und Abstände desselben zur Kathode eingestellt werden können. Damit kann auch ein extrem feiner Strahl mit einer entsprechend verminderten Leistung erhalten werden. Ist eine Regenerierung der Kathode vorgesehen, kann die Anlage über längere Zeit wartungsfrei arbeiten, während bei der herkömmlichen Anlage die Wolframkathode jeweils nach einigen Tagen gewechselt werden muss.

Bei einer Modifikation der in Fig. 1 gezeigten Ausführungsform kann an dem Gehäuse 11 des Teilchenstrahlgenerators 10 eine weitere Pumpe (nicht gezeigt) vorgesehen sein, zum Abpumpen der von der Pumpe 26 abgesaugten Teilchen. Diese weitere Pumpe kann beispielsweise an einer Außenwand des zweiten Gehäuseabschnitts 14 oder eines darauf folgenden Abschnitts vorgesehen sein. Eine an einer Außenwand des zweiten Gehäuseabschnitts 14 vorgesehene Pumpe kann die auf den Rotor 32 treffenden und auf diese Weise nach außen beschleunigten Teilchen abpumpen, beispielsweise indem in Entsprechung zu den Rotorebenen eine Mehrzahl von Ansaugöffnungen vorgesehen ist. Dadurch gelangen noch weniger Teilchen aus dem zweiten Gehäuseabschnitt 14 in den ersten Gehäuseabschnitt 12.

Bei einigen Ausführungsformen können die Rotorschaufeln 44 stärker verkippt werden bzw. sogar senkrecht stehen. Bei senkrecht stehenden Rotorschaufeln weisen diese dann keine Pumpenfunktion auf, sondern dienen lediglich dazu, Teilchen daran zu hindern, zurück in den Strahlerzeugungsraum S zu gelangen. Demzufolge können weniger Schaufeln verwendet werden. Ferner kann das Zeitintervall, in dem ein Teilchenstrahl durch die Rotorschaufeln hindurchtreten kann, vergrößert werden. Eine solche rotierende Einheit, die keine Pumpenfunktion aufweist, ist leichter herzustellen als eine Turbomolekularpumpe. Entsprechend können auch die Statorschaufeln weggelassen werden. Sowohl bei einer Pumpe als auch bei einem Rotor, der keine Pumpenfunktion hat, ist die oberste Ebene von Rotorschaufeln bzw. der Rotor 32 vorzugsweise benachbart zu der Strahldurchgangsöffnung 21 a angeordnet, beispielsweise in einem Abstand zwischen etwa 1 mm und 5mm zu der Strahldurchgangsöffnung.

Wenn wie beim Elektronenstrahlbohren lediglich ein gepulster Strahl benötigt wird, kann es ferner vorteilhaft sein, eine verschließbare Blende wie die Trennwand 21 zwischen dem Strahlerzeugungsraum S und dem restlichen Teil des Teilchenstrahlgenerators bzw. der Arbeitskammer vorzusehen, die immer nur kurzzeitig für den Strahlpuls geöffnet wird, beispielsweise unter Verwendung eines Piezo-Aktors oder dergleichen.

In einem Abschnitt stromabwärts des Rotors 32 können weitere synchron zu dem Rotor 32 rotierende Blenden vorgesehen sein, um das beim Bohren wegspritzende Material von dem Strahlerzeugungsraum fernzuhalten. Dies könnte beispielsweise in Form von langsamer rotierenden Blenden mit einer Vielzahl von Löchern entlang des Umfangs verwirklicht sein.

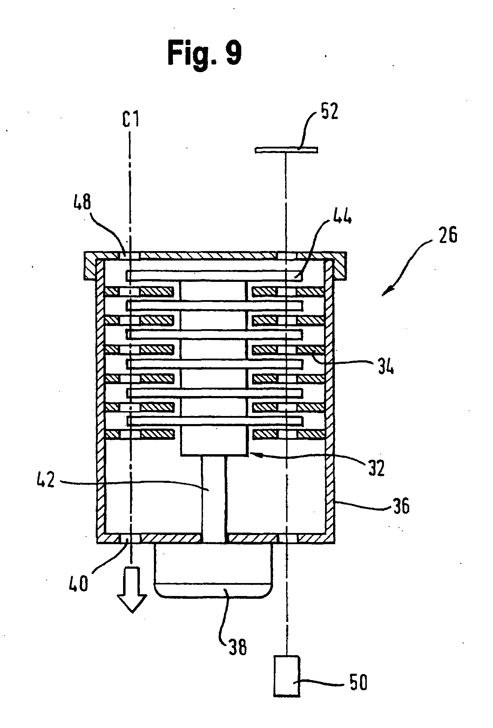

Eine besonders einfache Steuerung eines zum Auslösen von Elektronen aus einer Fotokathode verwendeten Hauptlasers kann durch Verwendung eines Steuerlasers 50 erzielt werden, der wie in Fig. 9 gezeigt einen Lichtstrahl erzeugt, der parallel zu dem Teilchenstrahl auf der gegenüberliegenden Seite eines symmetrisch ausgebildeten Rotors 32 durch denselben geht. Dieser Steuerlaserstrahl weist eine geringere Intensität auf, so dass er kontinuierlich emittiert werden kann. Bei einem Durchgang des Steuerlaserstrahls kann dieser über einen entsprechenden Sensor 52 detektiert werden, so dass der Hauptlaserstrahl zur Elektronenerzeugung lediglich dann erzeugt wird, wenn der Steuerlaserstrahl detektiert wird. Es können auch andere bekannte Sensoren zur Detektion der Drehstellung des Rotors 32 verwendet werden, und basierend auf deren Detektionsresultaten kann der Hauptlaser aktiviert werden. Auf diese Weise ergibt sich eine automatische Steuerung der Teilchenstrahlerzeugung in Abhängigkeit von der Drehstellung des Rotors 32.

Auch wenn der Rotor 32 hierin als Teil der Pumpe 26 beschrieben worden ist, ist offensichtlich, dass der Rotor auch als separates Bauteil in dem Teilchenstrahlgenerator vorgesehen sein kann, so dass er durch seine Drehung das Zurückströmen von Teilchen in den Strahlerzeugungsraum S verhindern kann, wie vorher beschrieben. Alternativ kann der Rotor auch als eine oder als mehrere, übereinander angeordnete rotierende Blenden ausgebildet sein, die ebenfalls das Zurückströmen von Teilchen in den Strahlerzeugungsraum S verhindern können. Diese Blenden können in Umfangsrichtung angeordnete Durchgangslöcher aufweisen, durch die der geeignet gepulste Teilchenstrahl zu der Austrittsöffnung 16 gelangen kann.

Bei einer Ausführungsform kann der Teilchenstrahl auch mit einem Tastverhältnis von etwa 1:1 erzeugt werden. Beispielsweise können dann die Flächen aller Rotorschaufeln der Pumpe 26 im äußeren Bereich auf wenigen Millimetern (entsprechend dem Strahldurchmesser) parallel zur Drehachse und radial ausgerichtet sein, so dass der Teilchenstrahldurchgang bei der Drehung des Rotors nur durch die relativ dünnen Außenkanten der Rotorschaufeln behindert wird. Dadurch kann der Teilchenstrahl jedes Mal dann, wenn der Durchgang zwischen jeweils zwei Rotorschaufeln möglich ist, eingeschaltet werden, so dass insgesamt eine höhere Einschaltdauer erhalten wird. Insbesondere kann der Teilchenstrahl sogar erst dann ausgeschaltet werden, wenn das Strahlzentrum auf die Enden der Pumpenschaufeln trifft, wodurch die Einschaltdauer bzw. das Ein/Aus-Tastverhältnis weiter erhöht werden kann. Dabei wird nur eine geringe Leistung des Teilchenstrahls absorbiert, beispielsweise 2 kW, die dann durch Wärmestrahlung abgegeben wird.

## Patentansprüche

1. Teilchenstrahlgenerator für geladene Teilchen (10), mit
einem Gehäuse (11), das einen ersten Gehäuseabschnitt (12) und einen zweiten Gehäuseabschnitt (14) aufweist,
einer Strahlerzeugungsvorrichtung (9), die innerhalb des ersten Gehäuseabschnitts (12) angeordnet ist und zum Erzeugen eines geladenen Teilchenstrahls (24) entlang einer Strahlachse (C1) angepasst ist,
einer Strahldurchgangsöffnung (21a), die das Innere des ersten Gehäuseabschnitts (12) mit dem Inneren des zweiten Gehäuseabschnitts (14) verbindet und durch die die Strahlachse (C1) geht,
**dadurch gekennzeichnet, dass** der zweite Gehäuseabschnitt (14) eine Pumpe (26) aufweist mit
einem Rotor (32), der innerhalb des zweiten Gehäuseabschnitts (14) angeordnet ist und zur Drehung um eine Drehachse (C2) und durch die Strahlachse (C1) angepasst ist,
bei dem der Rotor (32) mindestens eine Drehstellung aufweist, in der der geladene Teilchenstrahl (24) den Rotor (32) passieren kann, und der Teilchenstrahlgenerator dazu angepasst ist, den geladenen Teilchenstrahl (24) gepulst und synchronisiert mit der Drehung des Rotors (32) zu erzeugen.

2. Teilchenstrahlgenerator für geladene Teilchen nach Anspruch 1,
wobei die Pumpe (26) den Rotor (32) und mindestens eine Ebene von Statorschaufeln (35) aufweist, die derart angeordnet sind, dass in der mindestens einen Drehstellung des Rotors (32) ein Durchgang des Teilchenstrahls (24) durch den zweiten Gehäuseabschnitt (14) ermöglicht wird.

3. Teilchenstrahlgenerator für geladene Teilchen nach Anspruch 2, bei dem der Rotor (32) einen Rotorkörper (33) und mindestens eine Ebene von sich jeweils radial von dem Rotorkörper erstreckenden Rotorschaufeln (44) aufweist und wobei mindestens eine Rotorschaufel (44a, 44b) der mindestens einen Ebene von Rotorschaufeln (44) weggelassen oder verkürzt oder an einem äußeren Ende derselben im Wesentlichen parallel zu der Strahlachse (C1) ausgerichtet ist und/oder
mindestens eine Statorschaufel (35a) der mindestens einen Ebene von Statorschaufeln (35) an einer der Strahlachse (C1) entsprechenden Position weggelassen ist oder ein Durchgangsloch (37) aufweist.

4. Teilchenstrahlgenerator für geladene Teilchen nach einem der vorhergehenden Ansprüche, bei dem die Strahlerzeugungsvorrichtung (9) eine Fotokathode (18) aufweist, die zum Erzeugen des Teilchenstrahls (24) durch Auslösen von Elektronen unter Einstrahlung von Laserlicht angepasst ist.

5. Teilchenstrahlgenerator für geladene Teilchen nach einem der vorhergehenden Ansprüche, bei dem der Rotor (32) derart ausgebildet ist, dass bei einer Erzeugung des Teilchenstrahls (24) mit einem Ein/Aus-Tastverhältnis von etwa 1:1 die von dem sich drehenden Rotor (32) absorbierte Strahlleistung weniger als etwa 2 kW beträgt.

## Claims

1. Particle beam generator for charged particles (10), with a housing (11) consisting of a first housing section (12) and a second housing section (14), a beam generation device (9), which is located inside the first housing section (12) and is modified to generate a charged particle beam (24) along a beam axis (C1), a beam aperture (21a), which connects the inside of the first housing section (12) with the inside of the second housing section (14), and through which the beam axis (C1) passes, **characterised by** the fact that the second housing section (14) is equipped with a pump (26) with a rotor (32), which is located inside the second housing section (14), and is modified to rotate around a rotation axis (C2) and through the beam axis (C1), in which the rotor (32) has at least one rotation position in which the charged particle beam (24) can pass the rotor (32), and the particle beam generator is modified to generate the charged particle beam (24) in pulses synchronised with the rotation of the rotor (32).

2. Particle beam generator for charged particles in accordance with Claim 1, in which the pump (26) holds the rotor (32) and at least one stage of stator blades (35), which are arranged so that in at least one rotation position of the rotor (32), the charged particle beam (24) passes through the second housing section (14).

3. Particle beam generator for charged particles in accordance with Claim 2, in which the rotor (32) has a rotor body (33) and at least one stage of rotor blades (44) extending radially out from the rotor body, and at least one rotor blade (44a, 44b) of at least one stage of rotor blades (44) is omitted or shortened, or at one outer end of the same is aligned parallel to the beam axis (C1), and/or at least one stator blade (35a) of at least one stage of stator blades (35) is omitted or has a passage aperture (37) at a position corresponding to the beam axis (C1).

4. Particle beam generator for charged particles in accordance with one of the above claims, in which the beam generation device (9) is provided with a photo-cathode (18), which is modified for the generation of the particle beam (24) by the release of electrons under irradiation with laser light.

5. Particle beam generator for charged particles in accordance with one of the above claims, in which the rotor (32) is designed so that during generation of the particle beam (24) at an on/off scanning ratio of approx. 1 : 1, the beam power absorbed by the rotating rotor (32) is less than approx. 2 kW.

## Revendications

1. Générateur de faisceau de particules pour particules chargées (10), avec un boîtier (11) présentant une première section de boîtier (12) et une deuxième section de boîtier (14), avec un dispositif de production de faisceau (9) étant disposé à l'intérieur de la première section de boîtier (12) et adapté à la production d'un faisceau de particules chargées (24) le long de l'un axe de faisceau (C1), avec une ouverture de passage de faisceau (21 a) reliant l'intérieur de la première section de boîtier (12) à l'intérieur de la deuxième section de boîtier (14) et passant au travers de l'axe de faisceau (C1), **caractérisé par le fait que** la deuxième section de boîtier (14) présente une pompe (26) avec un rotor (32) étant disposé à l'intérieur de la deuxième section de boîtier (14) et adapté à la rotation autour d'un axe de rotation (C2) et au travers de l'axe de faisceau (C1), le rotor (32) présentant au moins une position de rotation dans laquelle le faisceau de particules chargées (24) peut passer le rotor (32), et la générateur de faisceau de particules étant conçu afin de produire le faisceau de particules chargées (24) pulsé et synchronisé avec la rotation du rotor (32).

2. Générateur de faisceau de particules pour particules chargées selon l'exigence 1, la pompe (26) présentant le rotor (32) et au moins un niveau d'aubes de stator (35), celles-ci étant disposées de telle manière que, dans au moins l'une des positions de rotation du rotor (32), un passage du faisceau de particules (24) soit possible au travers de la deuxième section de boîtier (14).

3. Générateur de faisceau de particules pour particules chargées selon l'exigence 2 dans lequel le rotor (32) présente un corps de rotor (33) et au moins un niveau d'aubes de rotor (44) s'étendant respectivement en direction radiale à partir du corps de rotor, au moins une aube de rotor (44a, 44b) d'au moins l'un des niveaux d'aubes de rotor (44) étant omise ou raccourcie ou bien étant alignée à une extrémité extérieure de ce même niveau essentiellement parallèlement à l'axe de faisceau (C1) et/ou au moins une aube de stator (35a) d'au moins un niveau d'aubes de stator (35) étant omise à une position correspondant à l'un des axes de faisceau (C1) ou présentant un orifice de passage (37).

4. Générateur de faisceau de particules pour particules chargées selon l'une des exigences précédentes dans lequel le dispositif de production de faisceau (9) présente une photocathode (18) étant adaptée à la production du faisceau de particules (24) en libérant des électrons à la suite de l'irradiation par un rayonnement laser.

5. Générateur de faisceau de particules pour particules chargées selon l'une des exigences précédentes dans lequel le rotor (32) est conçu de telle manière que, lors d'une production du faisceau de particules (24) avec un rapport cyclique marche/arrêt d'environ 1:1, la puissance de rayonnement absorbée par le rotor en rotation (32) soit inférieure à environ 2 kW.
